# EUROPEAN PATENT APPLICATION

(11) **EP 3 310 144 A1**
(43) Date of publication of application: **18.04.2018**
(21) Application number: 17196115.4
(22) Date of filing: 12.10.2017
(51) Int. Cl.: H05K 7/20

(54) **JET IMPINGEMENT IMMERSION COOLING WITH SYNTHETIC EJECTOR**

(30) Priority: 12.10.2016 US 201615291160
(71) Applicant: Hamilton Sundstrand Corporation, Charlotte, NC 28217-4578 (US)
(72) Inventor: BOURAS, Scott R., Rockford, IL 61109 (US)
(74) Representative: Hughes, Andrea Michelle

(57) **Abstract**

A method and system including an immersion cooled line replaceable unit (LRU) with jet impingement immersion cooling are provided. The LRU including an integrated circuit (120) disposed in the immersion cooled LRU (100), and a synthetic jet ejector disposed in the immersion cooled LRU, wherein the synthetic jet ejector creates a submerged jet impingement flow of cooling fluid toward the integrated circuit.

## Description

### BACKGROUND

The subject matter disclosed herein generally relates to component cooling and, more particularly, to cooling an integrated circuit using immersion cooling along with other elements.

Immersion cooling is steadily progressing as a thermal management technology for high heat flux applications. Immersion cooling is a cooling practice by which components are submerged in a thermally but not electrically conductive liquid. For example, the coolant liquid is commonly mineral-based oil with dielectric properties. A limiting factor in this technology is the critical heat flux that can be obtained and the surface super heat from a given device.

Accordingly, there is a desire to provide an improved immersion cooling system and/or method.

### BRIEF DESCRIPTION

According to one embodiment an immersion cooled line replaceable unit (LRU) with jet impingement immersion cooling is provided. The LRU includes an integrated circuit disposed in the immersion cooled LRU, and a synthetic jet ejector disposed in the immersion cooled LRU, wherein the synthetic jet ejector creates a submerged jet impingement flow of cooling fluid toward the integrated circuit.

In addition to one or more of the features described above, or as an alternative, further embodiments may include, wherein the integrated circuit is a high heat flux device.

In addition to one or more of the features described above, or as an alternative, further embodiments may include, wherein the integrated circuit is an insulated-gate bipolar transistor (IGBT) die.

In addition to one or more of the features described above, or as an alternative, further embodiments may include, wherein the synthetic jet ejector includes a cavity with an opening that faces toward the integrated circuit, a piezoelectric baffle that oscillates in the cavity creating a high velocity flow area of cooling fluid toward the integrated circuit.

In addition to one or more of the features described above, or as an alternative, further embodiments may include, wherein the piezoelectric baffle further oscillates in the cavity creating the high velocity flow area that entrains the surrounding fluid to create the submerged jet impingement flow of cooling fluid.

In addition to one or more of the features described above, or as an alternative, further embodiments may include, wherein the synthetic jet ejector is adjacent to the integrated circuit such that the opening of the cavity of the synthetic jet ejector faces the integrated circuit, and wherein the submerged jet impingement flow of cooling fluid impinges onto the integrated circuit.

In addition to one or more of the features described above, or as an alternative, further embodiments may include a plurality of synthetic jet ejectors disposed in the immersion cooled LRU, wherein each of the plurality of synthetic jet ejectors direct a submerged jet impingement flow of cooling fluid toward the integrated circuit.

In addition to one or more of the features described above, or as an alternative, further embodiments may include a plurality of integrated circuits disposed in the immersion cooled LRU, wherein the plurality of integrated circuits are mounted on one or more inner surfaces of the immersion cooled LRU.

In addition to one or more of the features described above, or as an alternative, further embodiments may include, wherein the plurality of synthetic jet ejectors are arranged in a pattern along a plane parallel to a surface plane of the integrated circuit.

In addition to one or more of the features described above, or as an alternative, further embodiments may include, wherein the plurality of synthetic jet ejectors are arranged such that each of the ejectors are placed over a high heat point of the integrated circuit.

In addition to one or more of the features described above, or as an alternative, further embodiments may include a second integrated circuit disposed in the immersion cooled LRU, wherein the second integrated circuit is mounted on a second inner surface opposite the integrated circuit mounted on a first inner surface, and a second synthetic jet ejector disposed in the immersion cooled LRU adjacent to the synthetic jet ejector, wherein the second synthetic jet ejector creates a second submerged jet impingement flow of cooling fluid toward the integrated circuit and the second integrated circuit as the second synthetic jet ejector oscillates, and wherein the synthetic jet ejector creates the submerged jet impingement flow of cooling fluid toward the integrated circuit and the second integrated circuit as the synthetic jet ejector oscillates.

In addition to one or more of the features described above, or as an alternative, further embodiments may include, wherein the synthetic jet ejector is a dual opening ejector including a cavity with a first opening that faces toward the integrated circuit and a second opening that faces toward the second integrated circuit, and a piezoelectric baffle disposed between the first opening and the second opening in the cavity, wherein the piezoelectric baffle oscillates in the cavity creating a first high velocity flow area of cooling fluid toward the integrated circuit in a first direction of oscillation and a second high velocity flow area of cooling fluid toward the second integrated circuit in a second direction of oscillation.

In addition to one or more of the features described above, or as an alternative, further embodiments may include, wherein the second synthetic jet ejector is a second dual opening ejector including a second cavity with a third opening that faces toward the integrated circuit and a fourth opening that faces toward the second integrated circuit, and a second piezoelectric baffle disposed between the third opening and the fourth opening in the second cavity, wherein the second piezoelectric baffle oscillates in the second cavity creating a third high velocity flow area of cooling fluid toward the integrated circuit in the first direction of oscillation and a fourth high velocity flow area of cooling fluid toward the second integrated circuit in the second direction of oscillation.

In addition to one or more of the features described above, or as an alternative, further embodiments may include, wherein the piezoelectric baffle and the second piezoelectric baffle oscillate in an alternating pattern 180 degrees out of phase.

In addition to one or more of the features described above, or as an alternative, further embodiments may include, wherein the piezoelectric baffle and the second piezoelectric baffle oscillate in phase.

According to one embodiment a computer implemented method for cooling an integrated circuit using immersion cooling is provided. The method includes receiving, at a controller, system information, generating, using the controller, a control signal based on the system information, creating, using a synthetic jet ejector, a submerged jet impingement flow of cooling fluid toward the integrated circuit based on the control signal, and impinging the jet impingement flow onto the integrated circuit surface.

In addition to one or more of the features described above, or as an alternative, further embodiments may include, creating a high velocity flow area that entrains the surrounding cooling fluid to create the submerged jet impingement flow of cooling fluid toward the integrated circuit.

In addition to one or more of the features described above, or as an alternative, further embodiments may include, generating, using the controller, a plurality of control signals based on the system information for controlling a plurality of synthetic jet ejectors, and creating, using the plurality of synthetic jet ejectors, a plurality of submerged jet impingement flows toward different points of the integrated circuit that correspond with the placement of the plurality of synthetic jet ejectors.

In addition to one or more of the features described above, or as an alternative, further embodiments may include, wherein system information includes one or more from a group consisting of sensor signals, temperature signals, user input, historic usage information, other system usage records, user specified operations, and user specified boundaries.

According to one embodiment a computer program product for jet impingement immersion cooling is provided. The computer program product includes a computer readable storage medium having program instructions embodied therewith, the program instructions executable by a processor to cause the processor to receive, at a controller, system information, generate, using the controller, a control signal based on the system information, create, using a synthetic jet ejector, a submerged jet impingement flow of cooling fluid toward the integrated circuit based on the control signal, and impinge the jet impingement flow onto the integrated circuit surface.

The foregoing features and elements may be combined in various combinations without exclusivity, unless expressly indicated otherwise. These features and elements as well as the operation thereof will become more apparent in light of the following description and the accompanying drawings. It should be understood, however, that the following description and drawings are intended to be illustrative and explanatory in nature and non-limiting.

### BRIEF DESCRIPTION OF THE DRAWINGS

The following descriptions should not be considered limiting in any way. With reference to the accompanying drawings, like elements are numbered alike:
FIG. 1 is an illustration of a side view of an immersion cooling system that includes a die and a fluid ejector in an immersion cooled LRU housing in accordance with one or more embodiments;
FIG. 2A is an illustration of a side view of an immersion cooling system that includes a plurality of die and fluid ejectors in a housing in accordance with one or more embodiments;
FIG. 2B is an illustration of a side view of an immersion cooling system that includes a plurality of die and fluid ejectors in a housing with opening forming a passage in accordance with one or more embodiments;
FIG. 2C is an illustration of a side view of an immersion cooling system that includes a plurality of die and fluid ejectors in a housing in accordance with one or more embodiments;
FIG. 3A is an illustration of a side view of an immersion cooling system that includes a die on a baseplate and a fluid ejector in accordance with one or more embodiments;
FIG. 3B is an illustration of a side view of an immersion cooling system that includes a die on a baseplate and a fluid ejector spaced apart from the die in accordance with one or more embodiments;
FIG. 4 is an illustration of a side view of an immersion cooling system that includes a plurality of die on corresponding baseplates and a plurality of fluid ejectors in accordance with one or more embodiments;
FIG. 5 is an illustration of a top view of an immersion cooling system that includes a die and a plurality of fluid ejectors in accordance with one or more embodiments;
FIG. 6 is an illustration of a top view of an immersion cooling system that includes a die and a plurality of fluid ejectors placed over select heat points in accordance with one or more embodiments;
FIG. 7 is an illustration of a top view of an immersion cooling system that includes a die and a plurality of fluid ejectors evenly spaced apart in a pattern in accordance with one or more embodiments; and
FIG. 8 is a flow chart of a method of immersion cooling using at least one fluid ejector in accordance with one or more embodiments;

### DETAILED DESCRIPTION

A detailed description of one or more embodiments of the disclosed apparatus and method are presented herein by way of exemplification and not limitation with reference to the Figures.

As shown and described herein, various features of the disclosure will be presented. Various embodiments may have the same or similar features and thus the same or similar features may be labeled with the same reference numeral, but preceded by a different first number indicating the figure to which the feature is shown. Thus, for example, element "a" that is shown in FIG. X may be labeled "Xa" and a similar feature in FIG. Z may be labeled "Za." Although similar reference numbers may be used in a generic sense, various embodiments will be described and various features may include changes, alterations, modifications, etc. as will be appreciated by those of skill in the art, whether explicitly described or otherwise would be appreciated by those of skill in the art.

Embodiments described herein are directed to the integration of one or more synthetic jet ejectors within an immersion cooled line replaceable unit (LRU). In particular, one or more embodiments add one or more synthetic ejectors to create submerged jet impingement cooling of high heat flux devices such as integrated circuits (for example, an insulated-gate bipolar transistor (IGBT) die) in an immersion cooled LRU. The one or more synthetic ejectors consist of a piezoelectric baffle which oscillates in a cavity with a small opening. The oscillation of the baffle creates a high velocity flow area which then entrains the surrounding fluid to create the submerged jet. The ejectors are located such that the jet that is created impinges directly onto the high heat flux device surface. The ejectors may be distributed with greater number in an area to correspond to areas of greater heat flux.

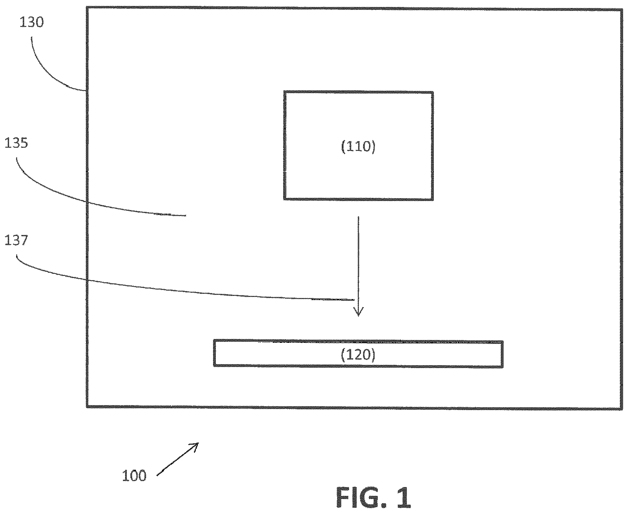

For example, turning now to FIG. 1, an illustration of a side view of an immersion cooling system 100, which can also be called an immersion cooled line replaceable unit (LRU), is shown. The immersion cooled LRU 100 includes integrated circuit 120, which can also be referred to as a die 120, and a fluid ejector 110 in a housing 130 in accordance with one or more embodiments. The immersion cooled LRU 100 includes a cooling fluid 135 that can be a dielectric cooling fluid 135 that fill the internal cavity of the housing 130 of the immersion cooled LRU 100. The cooling fluid is non-conductive and is designed to transfer heat. The integrated circuit 120 is provided within the housing such that the integrated circuit 120 is submerged in the cooling fluid 135. Additionally, the synthetic jet ejector 110 is provided in the housing 130 such that it is also submerged in the cooling fluid 135. Further, as shown, the synthetic jet ejector 110 is positioned such that it can create a submerged jet impingement flow of cooling fluid 137 toward the integrated circuit 120.

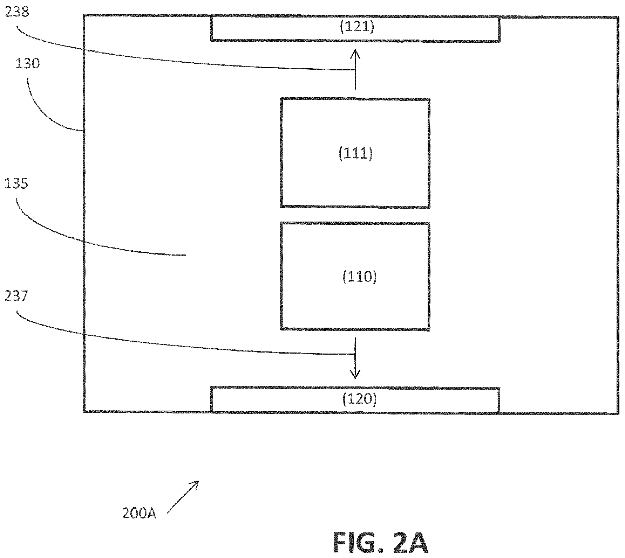

FIG. 2A is an illustration of a side view of an immersion cooling system 200A that includes a plurality of integrated circuits or die 120 and 121 and fluid ejectors 110 and 111 in a housing 130 in accordance with one or more embodiments. As shown the housing 130 is a fully enclosed fixture that is filled with cooling fluid 135. Further, the integrated circuits 120 and 121 are mounted on inner surfaces of the housing 130 as shown. Accordingly the integrated circuits 120 and 121 can connect with other circuits and/or wires to receive and transmit signals using the surface of the integrated circuits 120 and 121 that is mounted to the housing 130. Further the other surfaces of the integrated circuits 120 and 121 remain submerged in the cooling fluid 135. Further, the synthetic jet ejectors 110 and 111 are provided in the housing 130 such that they are also submerged in the cooling fluid 135. Further, as shown, the synthetic jet ejectors 110 and 111 are positioned such that they can each create a submerged jet impingement flow of cooling fluid 135 toward a respective integrated circuit 120 and 121. Specifically, synthetic jet ejector 110 creates a submerged jet impingement flow 237 of cooling fluid 135 toward the integrated circuit 120. Further, the synthetic jet ejector 111 creates a submerged jet impingement flow 238 of cooling fluid 135 toward the integrated circuit 121. Accordingly the cooling fluid 135 is moved along the integrated circuits' 120 and 121 surfaces which can improve heat dissipation.

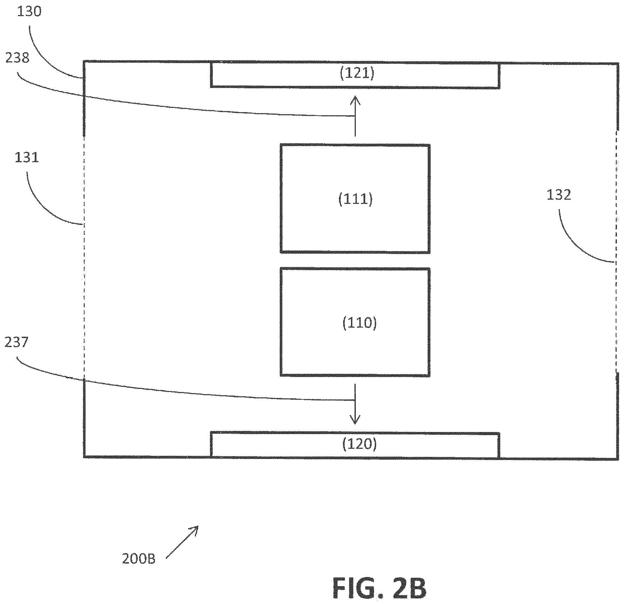

FIG. 2B is an illustration of a side view of an immersion cooling system 200B that includes a plurality of integrated circuits 120 and 121 and fluid ejectors 110 and 111 in a housing 130 with openings 131 and 132 forming a passage in accordance with one or more embodiments. As shown, the housing 130 has a first opening 131 on a surface perpendicular to either of the surfaces upon which the integrated circuits 120 and 121 are mounted. The housing also has a second opening 132 on a surface opposite the first opening 131. Accordingly a passage is provided that extends through the housing 130 from the first opening 131 to the second opening 132. Accordingly, a flow of cooling fluid can be provided through the immersion cooling system 200B.

Further, the synthetic jet ejectors 110 and 111 can be used to increase the amount and velocity of cooling fluid that comes in contact with the surfaces of the integrated circuits 120 and 121. For example, the integrated circuits 120 and 121 are mounted on different inner surfaces of the housing 130 as shown. Accordingly the integrated circuits 120 and 121 can connect with other circuits and/or wires to receive and transmit signals using the surface of the integrated circuits 120 and 121 that is mounted to the housing 130. Further the other surfaces of the integrated 120 and 121 remain submerged in the cooling fluid. Further, the synthetic jet ejectors 110, 111, 112, and 113 are provided in the housing 130 such that they are also submerged in the cooling fluid. Further, as shown, the synthetic jet ejectors 110 and 111 are positioned such that they can each create a submerged jet impingement flow of cooling fluid toward a respective integrated circuit 120 and 121. Specifically, synthetic jet ejector 110 creates a submerged jet impingement flow of cooling fluid toward the integrated circuit 120. Further, the synthetic jet ejector 111 creates a submerged jet impingement flow of cooling fluid toward the integrated circuit 121.

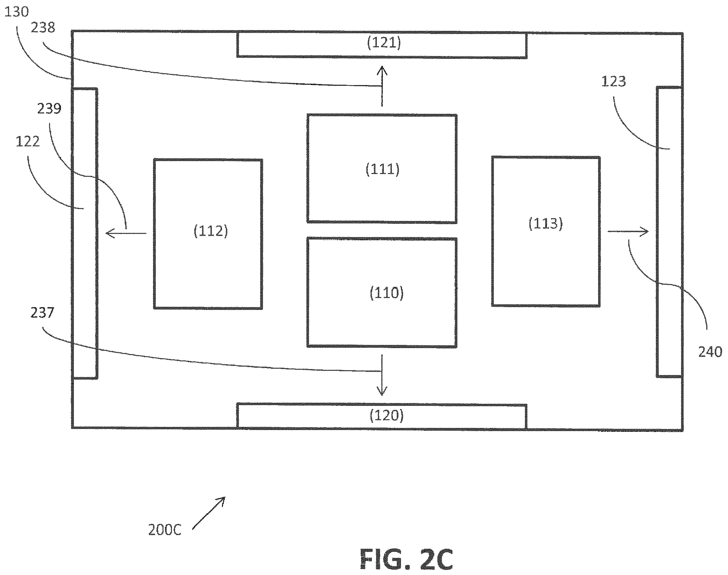

FIG. 2C is an illustration of a side view of an immersion cooling system 200C that includes a plurality of integrated circuits 120, 121, 122, and 123 and fluid ejectors 110, 111, 112, and 113 in a housing 130 in accordance with one or more embodiments. As shown the housing 130 is a fully enclosed fixture that is filled with cooling fluid. Further, the integrated circuits 120, 121, 122, and 123 are mounted on inner surfaces of the housing 130 as shown. Accordingly the integrated circuits 120, 121, 122, and 123 can connect with other circuits and/or wires to receive and transmit signals using the surface of the integrated circuits 120, 121, 122, and 123 that is mounted to the housing 130. Further the other surfaces of the integrated circuits 120, 121, 122, and 123 remain submerged in the cooling fluid 135. Further, the synthetic jet ejectors 110, 111, 112, and 113 are provided in the housing 130 such that they are also submerged in the cooling fluid 135.

Further, as shown, the synthetic jet ejectors 110, 111, 112, and 113 are positioned such that they can each create a submerged jet impingement flow of cooling fluid 135 toward a respective integrated circuit 120, 121, 122, and 123. Specifically, synthetic jet ejector 110 creates a submerged jet impingement flow 237 of cooling fluid 135 toward the integrated circuit 120. Further, the synthetic jet ejector 111 creates a submerged jet impingement flow 238 of cooling fluid 135 toward the integrated circuit 121. Accordingly the cooling fluid 135 is moved along the integrated circuits' 120 and 121 surfaces that can improve heat dissipation. Similarly, the synthetic jet ejector 112 creates a submerged jet impingement flow 239 of cooling fluid toward the integrated circuit 122 and synthetic jet ejector 113 creates a submerged jet impingement flow 240 of cooling fluid toward the integrated circuit 123. Accordingly the cooling fluid is moved along the integrated circuits' 122 and 123 surfaces which can improve heat dissipation.

3 A is an illustration of a side view of an immersion cooling system 300A that includes a die 320, which can also be called an integrated circuit, on a baseplate 330 and a fluid ejector 310 in accordance with one or more embodiments. The fluid ejector 310 includes a housing 310.3 that is formed with a cavity 310.2. The housing 310.3 also includes an opening that faces toward the die 320. The fluid ejector 310 further includes a piezoelectric baffle 310.1 that oscillates in the cavity 310.2 creating a high velocity flow area 350 of cooling fluid toward the die 320.

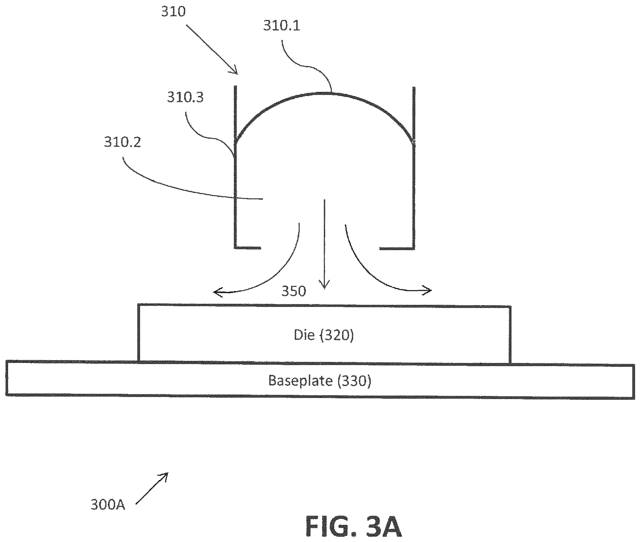

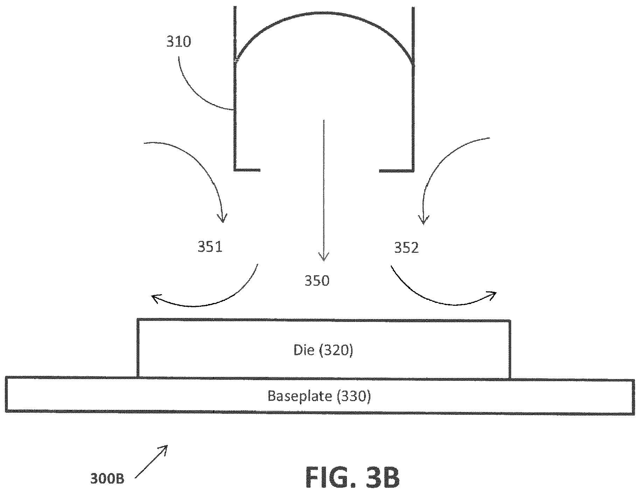

FIG. 3B is an illustration of a side view of an immersion cooling system that includes a die 320 on a baseplate 330 and a fluid ejector 310 spaced apart from the die 320 in accordance with one or more embodiments. As shown, the piezoelectric baffle of the fluid ejector 310 can oscillate in the cavity creating a high velocity flow area 350 of cooling fluid toward the die 320. Further, the piezoelectric baffle oscillates in the cavity creating the high velocity flow area 350 that entrains the surrounding fluid 351 and 352 to create the submerged jet impingement flow of cooling fluid.

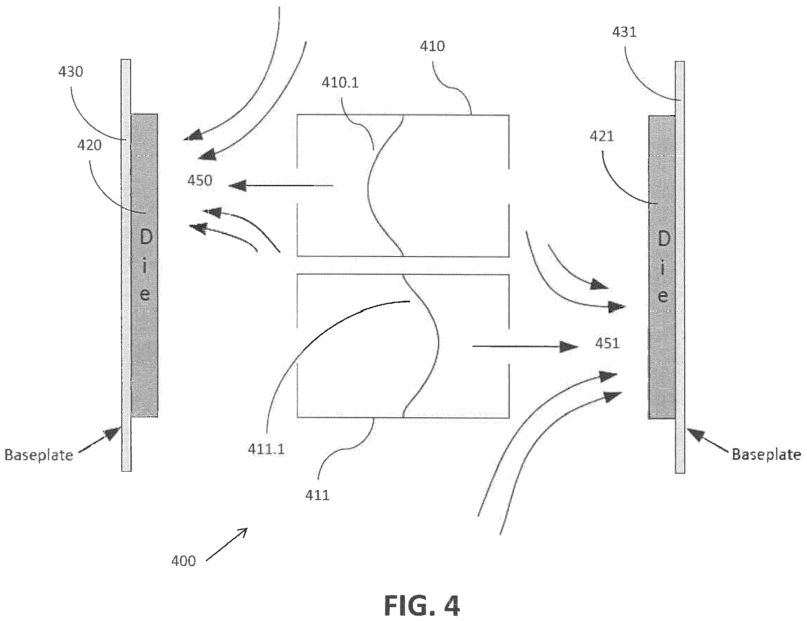

FIG. 4 is an illustration of a side view of an immersion cooling system 400, also called an immersion cooled LRU 400, which includes a plurality of die 420 and 421 on corresponding baseplates 430 and 431 and a plurality of fluid ejectors 410 and 411 in accordance with one or more embodiments. The plurality of fluid ejectors includes a first synthetic jet ejector 410 and as second synthetic jet ejector 411. The plurality of die includes a first integrated circuit 420 and second integrated circuit 421. The first integrated circuit 420 and second integrated circuit 421 are provided in the immersion cooled LRU 400. The second integrated circuit 421 is mounted on a second inner surface 431 opposite the first integrated circuit 420 mounted on a first inner surface 430. The second synthetic jet ejector 411 is disposed in the immersion cooled LRU adjacent to the synthetic jet ejector 410.

The first synthetic jet ejector 410 is a dual opening ejector that includes a cavity with a first opening that faces toward the integrated circuit 420 and a second opening that faces toward the second integrated circuit 421. The first synthetic jet ejector 410 also includes a first piezoelectric baffle 410.1 disposed between the first opening and the second opening in the cavity. The piezoelectric baffle 410.1 oscillates in the cavity creating a first high velocity flow area 450 of cooling fluid toward the first integrated circuit 420 in a first direction of oscillation and can create a second high velocity flow area of cooling fluid toward the second integrated circuit 421 in a second direction of oscillation when the piezoelectric baffle 410.1 oscillates the other direction.

Further, the second synthetic jet ejector 411 is a second dual opening ejector that includes a second cavity with a third opening that faces toward the first integrated circuit 420 and a fourth opening that faces toward the second integrated circuit 421. The synthetic jet ejector 411 also includes a second piezoelectric baffle 411.1 disposed between the third opening and the fourth opening in the second cavity. The second piezoelectric baffle 411.1 oscillates in the second cavity creating a third high velocity flow 451 area of cooling fluid toward the second integrated circuit 421 in the second direction of oscillation and can create a fourth high velocity flow area of cooling fluid toward the first integrated circuit 420 in the first direction of oscillation.

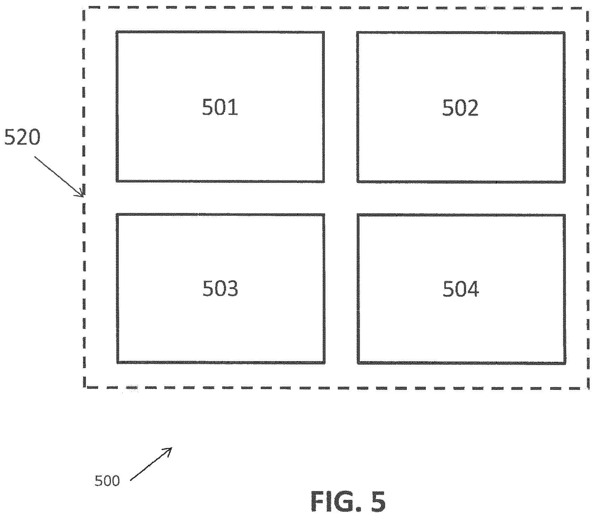

FIG. 5 is an illustration of a top view of an immersion cooling system 500 that includes a die 520 and a plurality of fluid ejectors 501, 502, 503, and 504 in accordance with one or more embodiments. As shown the fluid ejectors 501, 502, 503, and 504 are evenly arranged over the die 520. The fluid ejectors 501, 502, 503, and 504 can oscillate a plurality of different ways to move cooling fluid toward the die. For example, the fluid ejectors 501, 502, 503, and 504 can oscillate in unison, or said another way, the fluid ejectors 501, 502, 503, and 504 can oscillate in phase with the same frequency. The amplitude of oscillation of each can be adjusted too such that they are each the same or different according to the specific heat dissipation requirements of the die 520. Further the frequency of oscillation of each fluid ejector 501, 502, 503, and 504 can be the same, different, or any combination thereof. Further, according to another embodiment, the fluid ejectors 501 and 504 can oscillate 180 degrees out of phase as compared to fluid ejectors 502 and 503. Other oscillation patterns can also be provided such as oscillating fluid ejectors 501, 502, 503, and 504 in a clockwise or counterclockwise pattern.

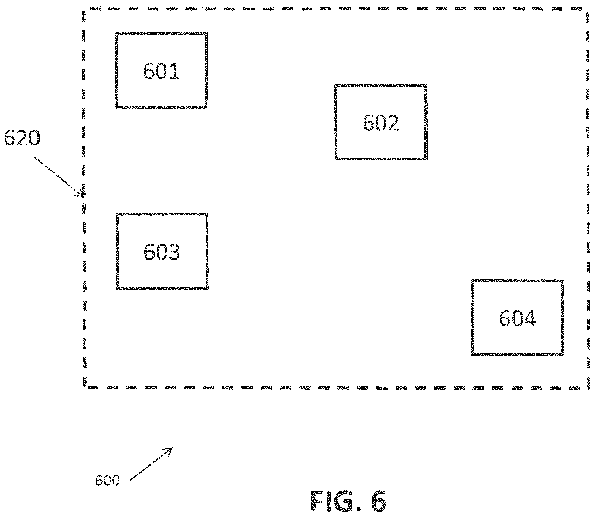

FIG. 6 is an illustration of a top view of an immersion cooling system 600 that includes a die 620 and a plurality of fluid ejectors 601, 602, 603, and 604 placed over select heat points in accordance with one or more embodiments. The fluid ejectors 601, 602, 603, and 604 can similarly oscillate in a number of different ways as described above with references to FIG. 5.

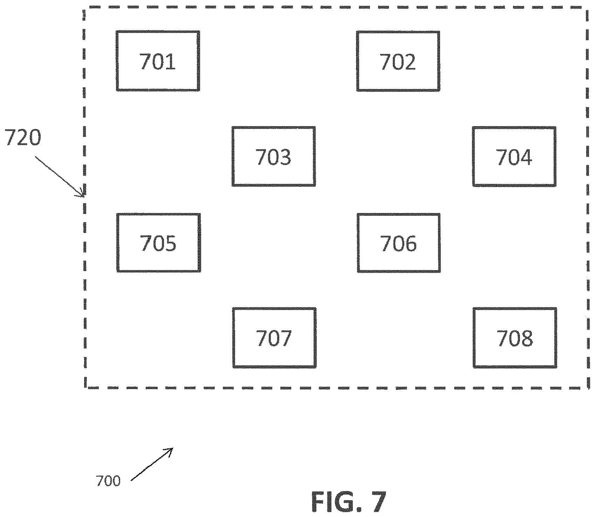

FIG. 7 is an illustration of a top view of an immersion cooling system 700 that includes a die 720 and a plurality of fluid ejectors 701, 702, 703, 704, 705, 706, 707, and 708 evenly spaced apart in a pattern in accordance with one or more embodiments. According to other embodiments, other geometric patterns can be provided for placing the fluid ejectors 701, 702, 703, 704, 705, 706, 707, and 708 as well as the number of fluid ejectors 701, 702, 703, 704, 705, 706, 707, and 708 can be adjusted.

According to one or more embodiments, the integrated circuit is a high heat flux device. According to one or more embodiments, the integrated circuit is an insulated-gate bipolar transistor (IGBT) die.

According to one or more embodiments, the synthetic jet ejector is adjacent to the integrated circuit such that the opening of the cavity of the synthetic jet ejector faces the integrated circuit. According to one or more embodiments, the submerged jet impingement flow of cooling fluid impinges onto the integrated circuit.

According to one or more embodiments, the plurality of synthetic jet ejectors are arranged in a pattern along a plane parallel to a surface plane of the integrated circuit. According to one or more embodiments, the plurality of synthetic jet ejectors are arranged such that each of the ejectors are placed over a high heat point of the integrated circuit.

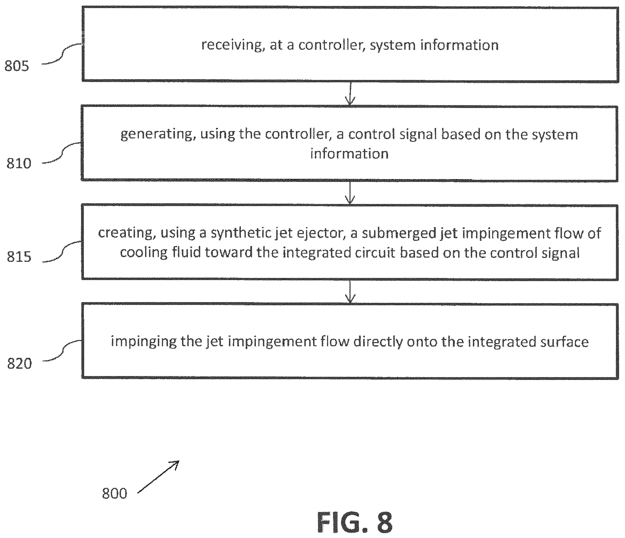

FIG. 8 is a flow chart of a method 800 of immersion cooling using at least one fluid ejector in accordance with one or more embodiments. The method 800 includes receiving, at a controller, system information (operation 805). The method 800 further includes generating, using the controller, a control signal based on the system information (operation 810). The method 800 also includes creating, using a synthetic jet ejector, a submerged jet impingement flow of cooling fluid toward the integrated circuit based on the control signal (operation 815). Further, the method 800 includes impinging the jet impingement flow onto the integrated circuit surface (operation 820).

According to one or more embodiments, the method can further include creating a high velocity flow area that entrains the surrounding cooling fluid to create the submerged jet impingement flow of cooling fluid toward the integrated circuit.

According to one or more embodiments, the method can further include generating, using the controller, a plurality of control signals based on the system information for controlling a plurality of synthetic jet ejectors. According to one or more embodiments, the method can further include creating, using the plurality of synthetic jet ejectors, a plurality of submerged jet impingement flows toward different points of the integrated circuit that correspond with the placement of the plurality of synthetic jet ejectors.

According to one or more embodiments, system information includes one or more from a group consisting of sensor signals, temperature signals, user input, historic usage information, other system usage records, user specified operations, and user specified boundaries.

Advantageously, embodiments described herein provide submerged jet impingement cooling to further enhance the two phase heat transfer from electronic devices. The synthetic jet ejector can improve overall heat transfer coefficient versus conventional pool boiling, which ultimately reduces device junction temperature for the same heat load thereby increasing device reliability. Alternatively, one or more embodiments allow for increased device capability due to lower thermal resistance from junction to fluid.

In accordance with one or more embodiments, immersion cooling using an ejector can increase the critical heat flux and improve the two phase heat transfer for an immersion cooled electronics assembly such as a motor controller. Therefore, immersion cooling using an ejector improves thermal performance enabling increased capability for the device.

While the present disclosure has been described in detail in connection with only a limited number of embodiments, it should be readily understood that the present disclosure is not limited to such disclosed embodiments. Rather, the present disclosure can be modified to incorporate any number of variations, alterations, substitutions, combinations, sub-combinations, or equivalent arrangements not heretofore described, but which are commensurate with the scope of the present invention as defined by the claims. Additionally, while various embodiments of the present disclosure have been described, it is to be understood that aspects of the present disclosure may include only some of the described embodiments.

The term "about" is intended to include the degree of error associated with measurement of the particular quantity based upon the equipment available at the time of filing the application. For example, "about" can include a range of ± 8% or 5%, or 2% of a given value.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment or embodiments, it will be understood by those skilled in the art that various changes may be made and equivalents may be substituted for elements thereof without departing from the scope of the present invention as defined by the claims. In addition, many modifications may be made to adapt a particular situation or material to the teachings of the present disclosure without departing from the essential scope thereof.

Therefore, it is intended that the present disclosure not be limited to the particular embodiment disclosed as the best mode contemplated for carrying out this present disclosure, but that the present disclosure will include all embodiments falling within the scope of the claims.

## Claims

1. An immersion cooled line replaceable unit (LRU) with jet impingement immersion cooling, the LRU comprising:
an integrated circuit (120) disposed in the immersion cooled LRU (100); and
a synthetic jet ejector (110) disposed in the immersion cooled LRU, wherein the synthetic jet ejector creates a submerged jet impingement flow of cooling fluid (135) toward the integrated circuit.

2. The immersion cooled LRU of claim 1, wherein integrated circuit is a high heat flux device.

3. The immersion cooled LRU of claim 1, wherein the integrated circuit is an insulated-gate bipolar transistor (IGBT) die.

4. The immersion cooled LRU of claim 1, wherein the synthetic jet ejector comprises:
a cavity (310.2) with an opening that faces toward the integrated circuit; and
a piezoelectric baffle (310.1) that oscillates in the cavity creating a high velocity flow area of cooling fluid toward the integrated circuit.

5. The immersion cooled LRU of claim 4, wherein the piezoelectric baffle further oscillates in the cavity creating the high velocity flow area that entrains the surrounding fluid to create the submerged jet impingement flow of cooling fluid.

6. The immersion cooled LRU of claim 4,
wherein the synthetic jet ejector is adjacent to the integrated circuit such that the opening of the cavity of the synthetic jet ejector faces the integrated circuit, and
wherein the submerged jet impingement flow of cooling fluid impinges onto the integrated circuit.

7. The immersion cooled LRU of claim 1, further comprising:
a plurality of synthetic jet ejectors (110, 111) disposed in the immersion cooled LRU, wherein each of the plurality of synthetic jet ejectors direct a submerged jet impingement flow of cooling fluid toward the integrated circuit.

8. The immersion cooled LRU of claim 1, further comprising:
a plurality of integrated circuits (120, 121) disposed in the immersion cooled LRU, wherein the plurality of integrated circuits is mounted on one or more inner surfaces of the immersion cooled LRU.

9. The immersion cooled LRU of claim 7,
wherein the plurality of synthetic jet ejectors are arranged in a pattern along a plane parallel to a surface plane of the integrated circuit.

10. The immersion cooled LRU of claim 7,
wherein the plurality of synthetic jet ejectors are arranged such that each of the ejectors are placed over a high heat point of the integrated circuit.

11. The immersion cooled LRU of claim 1,
a second integrated circuit (421) disposed in the immersion cooled LRU,
wherein the second integrated circuit is mounted on a second inner surface opposite the integrated circuit mounted on a first inner surface; and
a second synthetic jet ejector (411) disposed in the immersion cooled LRU adjacent to the synthetic jet ejector,
wherein the second synthetic jet ejector creates a second submerged jet impingement flow of cooling fluid toward the integrated circuit and the second integrated circuit as the second synthetic jet ejector oscillates, and
wherein the synthetic jet ejector creates the submerged jet impingement flow of cooling fluid toward the integrated circuit and the second integrated circuit as the synthetic jet ejector oscillates.

12. The immersion cooled LRU of claim 11,
wherein the synthetic jet ejector is a dual opening ejector comprising:
a cavity with a first opening that faces toward the integrated circuit and a second opening that faces toward the second integrated circuit; and
a piezoelectric baffle disposed between the first opening and the second opening in the cavity,
wherein the piezoelectric baffle oscillates in the cavity creating a first high velocity flow area of cooling fluid toward the integrated circuit in a first direction of oscillation and a second high velocity flow area of cooling fluid toward the second integrated circuit in a second direction of oscillation.

13. The immersion cooled LRU of claim 12,
wherein the second synthetic jet ejector is a second dual opening ejector comprising:
a second cavity with a third opening that faces toward the integrated circuit and a fourth opening that faces toward the second integrated circuit; and
a second piezoelectric baffle disposed between the third opening and the fourth opening in the second cavity,
wherein the second piezoelectric baffle oscillates in the second cavity creating a third high velocity flow area of cooling fluid toward the integrated circuit in the first direction of oscillation and a fourth high velocity flow area of cooling fluid toward the second integrated circuit in the second direction of oscillation.

14. A computer implemented method for cooling an integrated circuit using immersion cooling, the method comprising:
receiving, at a controller, system information;
generating, using the controller, a control signal based on the system information;
creating, using a synthetic jet ejector, a submerged jet impingement flow of cooling fluid toward the integrated circuit based on the control signal; and
impinging the jet impingement flow onto the integrated circuit surface.

15. The computer implemented method of claim 14, wherein creating the submerged jet impingement flow comprises:
creating a high velocity flow area that entrains the surrounding cooling fluid to create the submerged jet impingement flow of cooling fluid toward the integrated circuit.
